# EUROPEAN PATENT APPLICATION

(11) **EP 1 553 049 A2**
(43) Date of publication of application: **13.07.2005**
(21) Application number: 04019429.2
(22) Date of filing: 16.08.2004
(51) Int. Cl.: B81C 1/00

(54) **Method for manufacturing moulded micromechanical structures**

(30) Priority: 12.01.2004 US 755773
(71) Applicant: Agilent Technologies, Inc., Palo Alto, CA 94306 (US)
(72) Inventor: Grot, Annette C., Cupertino CA 95014 (US)
(74) Representative: Liesegang, Eva

(57) **Abstract**

A method for manufacturing refractive microlenses (60) and other three-dimensional micromechanical structures having desired properties. At least one first micromechanical structure (36) is formed by dispensing a first material (24) onto a surface (16) of a first substrate (12), a mold (42) is prepared using the at least one first micromechanical structure (36), and at least one second micromechanical structure (60) of a second material (54) is molded on a surface of a second substrate (50) using the mold (42). The at least one first micromechanical structure (36) is formed of a material (24) that is suitable to the procedure by which it is dispensed, and the at least one second micromechanical structure (60) is formed of a material (54) that provides desired properties.

## Description

### BACKGROUND OF THE INVENTION

### Technical Field of the Invention

The present invention relates generally to the field of micromechanical structures. More particularly, the invention relates to a method for manufacturing refractive microlenses and other three-dimensional micromechanical structures.

### Background of the Invention

Refractive microlenses, i.e., refractive lenses having a diameter of less than about one millimeter, are often used as optical interconnects and in various optical imaging applications. Known procedures for manufacturing refractive microlenses include a photoresist procedure and an ink-jet deposition procedure. In the photoresist procedure, a photoresist is patterned into cylinders, and the cylinders are melted to form the microlenses. In the ink-jet deposition procedure, an ink-jet dispensing apparatus dispenses microlens-forming material onto a surface in liquid form, and the material is hardened to form the microlenses.

In both the photoresist procedure and the ink-jet deposition procedure, the material used to form microlenses or other three-dimensional micromechanical structures must be compatible with the procedure; and, at the same time, provide properties that are desired for the formed structures. In the photoresist procedure, there are limitations in the shapes of micromechanical structures that can be formed. In the ink-jet deposition procedure, the material used to form the micromechanical structures must be suitable for deposition by the ink-jet dispensing apparatus and provide structures having desired properties; and it is often difficult to find a material that is optimized for both requirements.

There is, accordingly, a need for a method for manufacturing refractive microlenses and other three-dimensional micromechanical structures having desired properties.

### SUMMARY OF THE INVENTION

In accordance with the invention, a method for manufacturing refractive microlenses and other three-dimensional micromechanical structures having desired properties is provided.

A mold is prepared from first micromechanical structures that are formed by dispensing a material onto a first substrate, and then second micromechanical structures are molded on a second substrate using the mold. The first micromechanical structures can be formed of a material that is suitable to the procedure by which the material is dispensed, and the second micromechanical structures can be formed of a different material that provides desired properties. With the present invention, accordingly, desired properties of the second micromechanical structures, for example, optical, surface energy and environmental properties, can be optimized without regard to the requirements of the procedure by which the material forming the first micromechanical structures is dispensed.

### BRIEF DESCRIPTION OF THE DRAWINGS

Furthermore, the invention provides embodiments and other features and advantages in addition to or in lieu of those discussed above. Many of these features and advantages are apparent from the description below with reference to the following drawings.

FIGURES 1-7 schematically illustrate a method for manufacturing an array of refractive microlenses according to an exemplary embodiment of the invention. In particular,
FIGURE 1 is a schematic, cross-sectional side view that illustrates a patterned member used in the exemplary embodiment;
FIGURE 2 is a schematic, top plan view of the patterned member of FIGURE 1;
FIGURE 3 is a schematic, cross-sectional side view that illustrates a step of forming an array of micromechanical structures using the patterned member of FIGURES 1 and 2;
FIGURE 4 is a schematic, cross-sectional side view that illustrates a step of preparing a mold using the array of micromechanical structures formed by the step illustrated in FIGURE 3;
FIGURE 5 is a schematic, cross-sectional side view that illustrates the mold prepared by the step illustrated in FIGURE 4;
FIGURE 6 is a schematic, cross-sectional side view that illustrates a step of molding an array of refractive microlenses using the mold illustrated in FIGURE 5; and
FIGURE 7 is a schematic, cross-sectional side view that illustrates the array of refractive microlenses molded by the step illustrated in FIGURE 6.

### DETAILED DESCRIPTION OF THE EXEMPLARY EMBODIMENTS OF THE INVENTION

Embodiments in accordance with the invention provide methods for manufacturing three-dimensional micromechanical structures having desired properties.

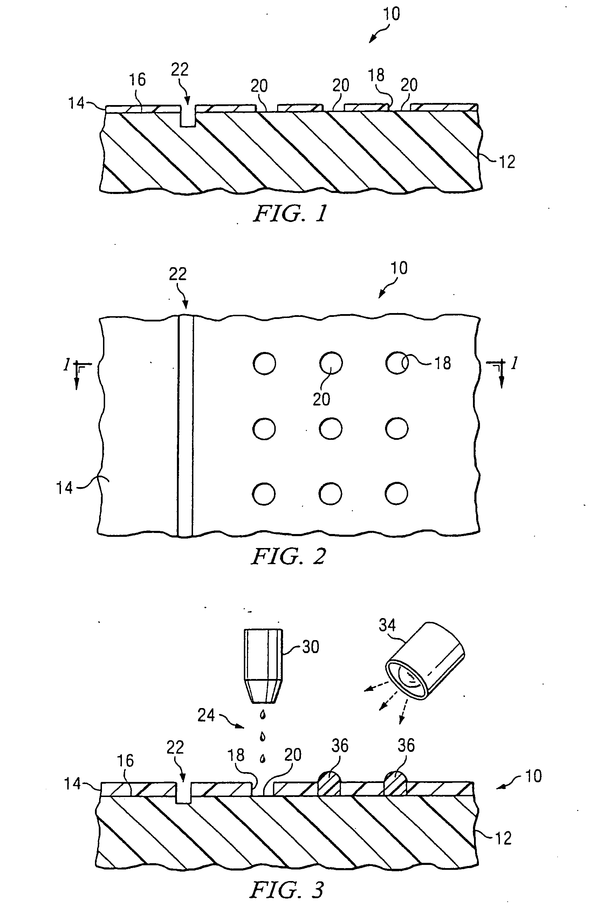

FIGURES 1-7 schematically illustrate a method for manufacturing an array of refractive microlenses according to an exemplary embodiment in accordance with the invention, and FIGURE 1 is a schematic, cross-sectional side view that illustrates a patterned member used in the exemplary embodiment. The patterned member is generally designated by reference number 10 and comprises substrate 12 having coating 14 on surface 16 thereof. Coating 14 is patterned to define a number of spaced, circular-shaped openings 18 that extend through the coating and expose a plurality of spaced, circular-shaped areas 20 on surface 16 of substrate 12. As shown in FIGURE 2, openings 18 are arranged to define a 3 x 3 array of openings; however, this is intended to be exemplary only as the coating can be patterned to define any desired number of openings arranged in any desired manner. A fiducial 22 is preferably etched in substrate 12 to facilitate component alignment during the manufacturing procedure.

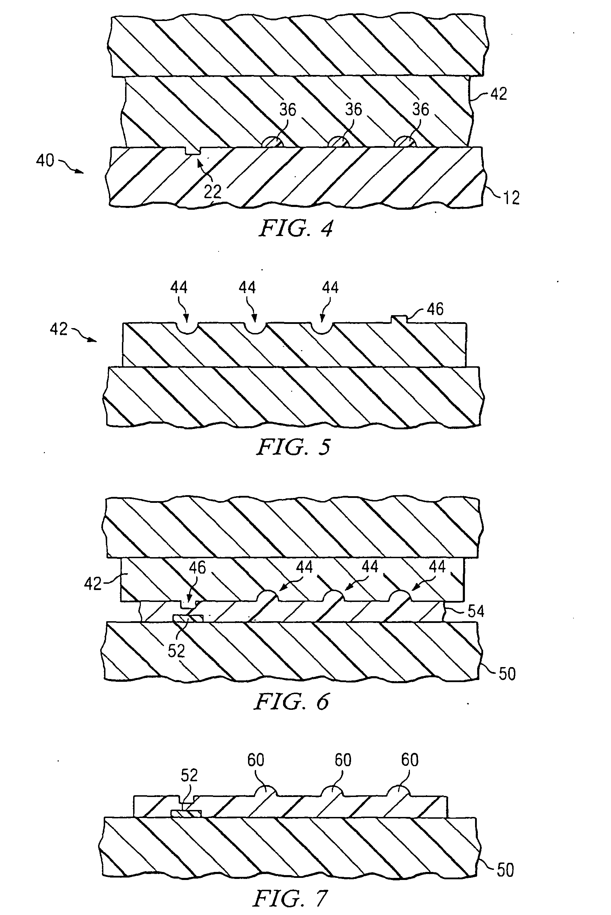

Openings 18 have a diameter of less than about one millimeter and define the size and locations of an array of micromechanical structures to be formed on surface 16 of substrate 12. In particular, FIGURE 3 is a schematic, cross-sectional side view that illustrates a step of forming an array of first micromechanical structures on patterned member 10. As shown in FIGURE 3, a small amount of polymer 24, in liquid form, is dispensed into each circular-shaped opening 18 in coating 14 by an ink-jet dispensing apparatus schematically illustrated at 30. The dispensed polymer spreads out in each opening forming hemispherical-shaped structures that cover surface areas 20 defined by the openings, and is then hardened, for example, by radiation from an optical source schematically illustrated at 34, to provide an array of first micromechanical structures 36 on areas 20 of surface 16 of substrate 12. Following hardening, coating 14 is removed from surface 16 to provide mold-forming member 40 illustrated in FIGURE 4.

Substrate 12 is preferably a wafer of silicon or another material, for example, glass or ceramic, that is easily wetted by polymer 24. A silicon substrate is especially suitable because it can also be easily patterned to provide a good quality fiducial thereon. Other materials may also be used for substrate 12, and the invention is not limited to any particular substrate material.

Coating 14 is a release layer of a material that is substantially non-wetting with respect to polymer 24. As a result, when polymer 24 is dispensed into openings 18, the polymer will spread out and fully cover areas 20 on surface 16, but will not adhere to coating 14. A suitable material for coating 14 is a fluoropolymer, although other materials, for example, other materials that are substantially non-wetting with respect to polymer 24, can also be utilized, and the invention is not limited to any particular coating material.

Polymer 24 is preferably an optically curable polymer, for example, a UV curable polymer. J91 polymer, a UV curable polymer available from Summers Lab, is suitable because it readily beads up into a hemispherical shape on a Si wafer. Other materials including epoxys, polyamides, and other optically curable or heat curable polymers may also be used, and the invention is not limited to any particular polymer.

Suitable ink-jet dispensing apparatus 30 include, for example, the JETLAB inkjet dispenser available from Microfab, Inc., and the AUTODROP ink jet dispenser available from Microdrop of Germany.

FIGURE 4 is a schematic, cross-sectional side view that illustrates a step of preparing mold 42 using mold-forming member 40 formed by the step illustrated in FIGURE 3; and, as best shown in FIGURE 5, the surface profile of mold-forming member 40 is replicated onto mold 42. In particular, mold 42 includes an array of cavities 44 corresponding to the array of first micromechanical structures 36 on mold-forming member 40, and fiducial 46 corresponding to fiducial 22 on mold-forming member 40. Mold 42 may be formed of a polymer such as J91 polymer or PDMS (polydimethylsiloxane) polymer available from Dow Chemical under the SYLGARD 184 trademark. Ni plating can also be used to form a mold suitable for injection molding. Other materials can also be used for mold 42 and the invention is not limited to a particular mold material.

As shown in FIGURE 6, mold 42 is aligned with substrate 50, by aligning fiducial 46 on the mold with aligning structure 52 on substrate 50; and an array of refractive microlenses is then cast using a polymer 54, for example, an optically curable polymer different from polymer 24 that is used to cast the array of micromechanical structures 36. The resultant product is illustrated in FIGURE 7 and comprises an array of refractive microlenses 60 on substrate 50.

In the exemplary embodiment of FIGURES 1-7, polymer 24, dispensed by ink-jet dispensing apparatus 30, is different from polymer 54, used to form the array of refractive microlenses 60. As a result, polymers 24 and 54 can each be selected to provide optimum properties for its intended use. For example, as indicated above, polymer 24 can be J91 polymer or another polymer that is especially suited for being dispensed by an ink-jet dispensing apparatus, e.g., a polymer that has surface energy properties suitable for use in an ink-jet dispensing apparatus, without regard to the properties that are desired for the microlenses. At the same time, polymer 54 can be a polymer selected to provide refractive microlenses having desired properties without regard to its suitability for use in an ink-jet dispensing apparatus. For example, polymer 54 may be selected to provide desired optical properties such as a high degree of transparency, desired surface energy properties such as wetability, and desired environmental properties such as stability to thermal cycling, heat and humidity. In the exemplary embodiment described herein, polymer 54 is UMS182 polymer available from Gelest , used in conjunction with a UV initiator such as IRGACURE184 available from Ciba-Geigy. Other polymers, including other optically curable or heat curable polymers that provide refractive microlenses having desired properties may also be used, and the invention is not limited to any particular material for microlenses 60.

In the exemplary embodiment described herein, substrate 50 comprises a Pyrex substrate. Pyrex is a particularly suitable substrate material for microlenses because it is relatively smooth, and the perimeter of the molded microlenses will not assume any roughness from the substrate. Other materials may also be used for substrate 50, and the invention is not limited to any particular substrate material.

With the method of the present invention also, both patterned member 40 and mold 42 are reusable to enhance manufacturing efficiency.

According to further exemplary embodiments of the invention, other three-dimensional micromechanical structures having different shapes may be manufactured. For example, structures such as stand-offs, mechanical stops, optical waveguides and shallow wall structures may be manufactured by the method described with reference to FIGURES 1-7. When manufacturing non-optical micromechanical structures, opaque polymers or solders can be used for the structures, if desired. Also, when non-optical micromechanical structures are being manufactured, substrate 50 can be formed of plastic, metal or other materials that are suitable for the particular structures being manufactured.
While what has been described constitutes exemplary embodiments of the present invention, it should be recognized that the invention can be varied in many respects without departing therefrom. For example, although FIGURE 7 illustrates an array of refractive microlenses on one surface of a substrate, for parallel optical interconnects, microlens arrays can be formed on both the front and back surfaces of a substrate. Because the invention can be varied in many ways, it should be understood that the invention should be limited only insofar as is required by the scope of the following claims.

## Claims

1. A method for manufacturing at least one micromechanical structure (60), comprising:
forming at least one first micromechanical structure (36) of a first material (24) by dispensing said first material (24) onto a surface (16) of a first substrate (12);
preparing a mold (42) from said at least one first micromechanical structure (36); and
molding at least one second micromechanical structure (60) of a second material (54) on a surface of a second substrate (50) using said mold (42).

2. The method according to Claim 1, wherein said first material (24) comprises a first polymer (24), and wherein said dispensing comprises dispensing said first polymer (24) onto said surface (16) of said first substrate (12) by an ink-jet dispensing apparatus (30).

3. The method according to Claim 2, wherein said forming further comprises curing said dispensed first polymer (24) with optical radiation.

4. The method according to Claim 2, wherein said first substrate (12) is easily wetted by said first polymer (24).

5. The method according to Claim 4, and further including a patterned coating (14) on said surface (16) of said first substrate (12), said patterned coating (14) including at least one opening ( 18) defining at least one area (20) on said surface (16) of said first substrate (12) onto which said first polymer (24) is dispensed by said ink-jet-dispensing apparatus (30), said patterned coating (14) being substantially non-wetting with respect to said first polymer (24).

6. The method according to one of the preceding Claims, wherein said at least one second micromechanical structure (60) comprises at least one microlens (60).

7. The method according to Claim 6, wherein said first material (24) comprises J91 polymer and said first substrate (12) comprises a silicon substrate, and wherein said second substrate (50) comprises a Pyrex substrate, and said second material (54) comprises GELEST UMS 182 polymer.

8. A micromechanical structure manufactured by the method of Claim 1.

9. A method for manufacturing at least one microlens (60), comprising:
forming at least one micromechanical structure (36) of a first material (24) by dispensing said first material (24) onto a surface (16) of a first substrate (12) by an ink-jet dispensing apparatus (30);
preparing a mold (42) from said at least one first micromechanical structure (36); and
molding at least one microlens (60) of a second material (54) on a surface of a second substrate (50) using said mold (42).

10. The method according to Claim 9, wherein said first material (24) comprises a first polymer (24), and wherein said first substrate (12) comprises a material that is easily wetted by said first polymer (24), and further including a coating (14) on said surface (16) of said first substrate (12), said coating (16) including at least one opening (18) defining at least one area (20) on said surface (16) of said first substrate (12) onto which the first polymer (24) is dispensed by said ink-jet dispensing apparatus (30), said coating (14) being substantially non-wetting with respect to said first polymer (24).
